# EUROPÄISCHE PATENTSCHRIFT

(11) **EP 2 862 278 B1**
(45) Veröffentlichungstag und Bekanntmachung des Hinweises auf die Patenterteilung: **22.03.2017**
(21) Anmeldenummer: 13726528.6
(22) Anmeldetag: 04.06.2013
(51) Int. Cl.: H03K 17/955

(54) **ANNÄHERUNGSERFASSUNGSVORRICHTUNG**
APPROACH DETECTION DEVICE
DISPOSITIF DE DÉTECTION DE PROXIMITÉ

(30) Priorität: 13.06.2012 DE 102012105117
(43) Veröffentlichungstag der Anmeldung: 22.04.2015
(73) Patentinhaber: Huf Hülsbeck & Fürst GmbH & Co. KG, 42551 Velbert (DE)
(72) Erfinder: BUSCHMANN, Gerd, 42553 Velbert (DE); RAULIN, Sebastian, 45147 Essen (DE)
(74) Vertreter: Zenz Patentanwälte Partnerschaft mbB
(86) Internationale Anmeldenummer: PCT/EP2013/061418
(87) Internationale Veröffentlichungsnummer: WO 2013/186077

(56) Entgegenhaltungen:
- EP-A1- 1 284 335
- EP-A1- 2 275 243
- EP-A2- 1 582 670
- DE-A1-102005 061 755
- US-A1- 2008 067 052
- US-A1- 2008 290 668
- US-A1- 2010 315 267
- US-A1- 2011 057 773

## Beschreibung

Die Erfindung betrifft eine Annäherungserfassungsvorrichtung mit einem Sensorsystem zum Erfassen der Annäherung eines Benutzers. Insbesondere betrifft die Erfindung Annäherungserfassungsvorrichtungen mit einem kapazitiven Annäherungssensor.

Kapazitive Sensoren bzw. entsprechende Systeme sind aus dem Stand der Technik bekannt und können berührungslos die Annäherung eines Benutzers erfassen. Dazu wird die Veränderung der Kapazität einer Elektrodenanordnung gemessen, wobei die Kapazität von dem Abstand eines Körperteils des Benutzers zu der Elektrodenanordnung abhängig ist. Eine entsprechende Elektrodenanordnung ist beispielsweise in der DE 10 2005 061 755 A1 beschrieben.

Kapazitive Sensorsysteme werden unter anderem bei "Passive Entry"-Systemen verwendet, bei denen der Benutzer nicht mehr aktiv eine Taste einer Funkfernbedienung zum Öffnen eines Fahrzeuges zu betätigen braucht. Vielmehr reicht es aus, dass der Benutzer eine auch als ID-Geber (Identifikationsgeber) bezeichnete Funkfernbedienung mit sich führt. Sobald sich ein Benutzer einer Annäherungserfassungsvorrichtung nähert, wird dies von dem kapazitiven Annäherungssensor erfasst, woraufhin ein in dem Kraftfahrzeug angeordnetes Steuergerät über eine Sendeantenne ein Funksignal an den ID-Geber sendet, welches den ID-Geber aus dem sogenannten "Sleep-Mode" weckt. Der Empfang des Aufwecksignals initiiert einen Funkdialog zwischen dem ID-Geber und dem Steuergerät des Kraftfahrzeuges, bei welchem die Berechtigung bzw. Nicht-Berechtigung des ID-Gebers zum Öffnen des Kraftfahrzeuges ermittelt wird. Sofern im Laufe des Funkdialoges die Berechtigung des ID-Gebers ermittelt wird, wird ein dem Sensorsystem zugeordnetes Schloss des Kraftfahrzeuges entriegelt, so dass durch eine anschließende Betätigung einer Handhabe oder die Ausführung bestimmter Gesten ein Schloss (Türschloss, Kofferraum, Motorhaube) geöffnet werden kann.

Die üblicherweise verwendeten kapazitiven Annäherungssensoren sind stark von Umgebungsbedingungen abhängig; Luftfeuchtigkeit, Niederschläge und sonstige Einflüsse können die Kapazität des Sensorsystems beeinflussen, so dass die Detektion der Annäherung eines Körperteils des Bedieners aufgrund der Störeinflüsse erschwert ist.

Aus dem Stand der Technik sind beispielsweise Türgriffsysteme, bei welchen kapazitive Annäherungssensoren Verwendung finden, beschrieben, die gegenüber Umwelteinflüssen geschützt sind. Beispielsweise offenbart die EP 03 100 728.9 ein System, bei welchem die kapazitive Sensoranordnung hinter einer Gehäusewandung angeordnet ist. Der Raum zwischen der Sensoranordnung und der Gehäusewandung ist mit einem elektrisch isolierenden Material gefüllt, um das Eintreten von Feuchtigkeit oder anderweitigen Fremdstoffen, die die Kapazität des Sensorsystems beeinflussen könnten, zu verhindern.

Insbesondere in der Nähe der Elektroden des kapazitiven Sensors ist der Einfluss störender Effekte möglichst zu vermeiden. Dazu wird im Stand der Technik beispielsweise vorgeschlagen, kapazitive Sensoren in einer Vergussmasse einzubetten, um so eine unmittelbare Beeinflussung der Sensorflächen zu verhindern. Gemäß diesem Stand der Technik wird der gesamte Raum zwischen solch einer vergossenen Elektrodenanordnung und einer Wandung eines Türgriffs mit isolierendem Material verfüllt.

Nachteilig bei diesem System ist jedoch, dass der Einfluss des Materials, auch wenn er schädliche Einflüsse von dem Detektionsbereich des kapazitiven Sensors abhält, der Detektionsempfindlichkeit des kapazitiven Sensors abträglich ist. Zwar ist das Material elektrisch isolierend, die Kapazität wird von diesem Dielektrikum dennoch beeinflusst.

Nachteilig bei den oben genannten Lösungen gemäß dem Stand der Technik ist es ferner, dass die verwendeten Bauteile spezielle für eine Sensorvorrichtung hergestellt werden müssen, das heißt nicht bei ähnlichen Systemen verwendet werden können. Es sind demnach für jede Anwendung spezielle Bauteile zu fertigen, was die Kosten für die bekannten Vorrichtungen erhöht.

Aus der US 2008/0290688 A1 ist ein Kraftfahrzeugtürgriff mit einer Annäherungserfassungsvorrichtung bekannt. Die Annäherungserfassungsvorrichtung umfasst u.a. einen Sensor, der in einem Aufnahmeraum angeordnet ist, der nach außen, also vom Fahrzeug weg führend, offen ist. Zum Schutz des Sensors ist dieser mit einem Dichtmittel, welches sich über die Öffnung des Aufnahmeraums hinaus erstreckt, versehen. Die in der US 2008/0290688 A1 offenbarte Annäherungserfassungsvorrichtung ist für den Einsatz in einem Kraftfahrzeugtürgriff optimiert, insbesondere aufgrund der Beschaffenheit des Dichtmittels.

Um eine Anbringung an einem Karosserieteil zu ermöglichen, wird üblicherweise ein komprimierbares Dichtmittel verwendet. Das komprimierbare Dichtmittel bedingt jedoch den Nachteil, dass der Expansionsdruck dieses Dichtmittels nach Anbringung ein Loslösen der Annäherungserfassungsvorrichtung von der Karosserie fördert.

Aufgabe der Erfindung ist es, eine Annäherungserfassungsvorrichtung zu schaffen, bei welcher die Gefahr des Loslösens von einem die Vorrichtung tragenden Karosseriebauteil vermindert ist.

Die Aufgabe wird erfindungsgemäß durch eine Annäherungserfassungsvorrichtung gemäß Anspruch 1 gelöst. Die erfindungsgemäße Annäherungserfassungsvorrichtung umfasst einen einen ersten Aufnahmeraum aufweisenden Sensorträger, wobei in dem ersten Aufnahmeraum des Sensorträgers eine Sensorelektronik angeordnet ist, die zumindest einen mit einer Auswerteschaltung gekoppelten kapazitiven Annäherungssensor mit einer aktiven kapazitiven Fläche zur Erfassung von Annäherungen aufweist.

Die Annäherungserfassungsvorrichtung umfasst ferner einen Trägerrahmen, der einen Befestigungsabschnitt umfasst, mit welchem die Annäherungserfassungsvorrichtung an einem Karosserieteil eines Kraftfahrzeuges befestigbar ist, sowie eine Detektionsöffnung.

Der Sensorträger ist derart an dem Trägerrahmen befestigt, dass die aktive kapazitive Fläche des kapazitiven Annäherungssensors zur Detektionsöffnung ausgerichtet und von dieser freigegeben ist, das heißt die aktive kapazitive Fläche nicht durch den Trägerrahmen verdeckt ist, um so eine Beeinflussung der Kapazität zu vermeiden.

In dem Bereich der Detektionsöffnung ist von der Detektionsöffnung selber und dem Sensorträger ein zweiter Aufnahmeraum gebildet, in welchem ein Dichtmittel angeordnet ist, welches in dem Aufnahmeraum auf dem Sensorträger zumindest im Bereich der aktiven kapazitiven Fläche des kapazitiven Annäherungssensors angeordnet ist.

Zum Ausgleich von Fertigungstoleranzen und zur Optimierung des Schutzes durch das Dichtmittel kann dieses im unbefestigten Zustand der Annäherungserfassungsvorrichtung über die durch den Befestigungsabschnitt des Trägerrahmens definierte Ebene hinausragen; bei der Befestigung an dem Karosserieteil findet dann eine Komprimierung des Dichtmittels in dem zweiten Aufnahmeraum statt.

Zur Verringerung des Expansionsdruckes des Dichtmittels ist es erfindungsgemäß vorgesehen, dass das Dichtmittel zumindest eine Durchgangsöffnung aufweist. In dem Bereich dieser Durchgangsöffnung, die zur Vermeidung eines Eintritts von beispielsweise Flüssigkeit keine Öffnung zu einem der Ränder des Dichtmittels aufweist, unterbleibt eine Kompression des Dichtmittels, wodurch der Expansionsdruck im Vergleich zu einem Dichtmittel ohne Durchgangsöffnung vermindert ist. Die Anzahl der Durchgangsöffnungen hängt von dem jeweiligen Anwendungsfall ab. Vorteilhaft an dieser Ausführungsform ist ferner, dass in den Bereichen der Durchgangsöffnung(en) überhaupt keine Störung des Detektionsvermögens des kapazitiven Sensors durch das Dichtmittel auftritt.

Die erfindungsgemäße Annäherungsvorrichtung ist vorteilhafterweise weitgehend modular aufgebaut, so dass einzelne Elemente der Annäherungsvorrichtung für verschiedene Anwendungsbereiche angepasst werden können. Bei unterschiedlichen Detektionsszenarien kann beispielsweise einfach eine andere Sensorelektronik in dem Sensorträger verbaut werden. Der Sensorträger und der Trägerrahmen sind vorzugsweise so aufeinander abgestimmt, dass keine aufwendige Befestigung aneinander notwendig ist. Beispielsweise kann der Sensorträger einfach in den Trägerrahmen eingeklipst bzw. eingerastet werden.

Bei dem Dichtmittel handelt es sich üblicherweise um einen komprimierbaren, vorzugsweise geschlossen-zelligen Schaumstoff, welcher dichtend gegenüber Flüssigkeiten, Fetten und sonstigen Fremdstoffen wirkt, der aber gleichzeitig aufgrund seiner zellartigen Struktur lediglich einen sehr geringen Einfluss auf das Detektionsvermögen des kapazitiven Sensors hat.

Die Tiefe des von dem Sensorträger und der Detektionsöffnung definierten Aufnahmeraums ist vorzugsweise geringer als die Höhe des Dichtmittels, das heißt das Dichtmittel ragt in einem nicht-befestigten Zustand der Annäherungserfassungsvorrichtung über die durch den Befestigungsabschnitt des Trägerrahmens definierte Ebene des Trägerrahmens hinaus und wird bei der Befestigung der Annäherungserfassungsvorrichtung über den Befestigungsabschnitt des Trägerrahmens in dem Aufnahmeraum komprimiert. Dadurch können Fertigungstoleranzen ausgeglichen werden, so dass stets sichergestellt ist, dass zumindest in dem Bereich der aktiven kapazitiven Fläche des kapazitiven Sensors eine optimale Schutzwirkung des Dichtmittels gegeben ist.

Durch den weitgehend modularen Aufbau und die Verwendung des Dichtmittels wird eine Annäherungserfassungsvorrichtung bereitgestellt, die kostengünstig hergestellt und universell eingesetzt werden kann und dabei gleichzeitig gegen Witterungseinflüsse geschützt ist.

Um bei der Befestigung der Annäherungserfassungsvorrichtung eine zu starke Komprimierung des Dichtmittels zu vermeiden, umfasst der Sensorträger bei einer bevorzugten Ausführungsform in dem von dem zweiten Aufnahmeraum freigegebenen Bereich zumindest eine zu der Durchgangsöffnung in dem Dichtmittel komplementäre Erhebung. Diese komplementäre Erhebung erstreckt sich nicht über die von dem Befestigungsabschnitt des Trägerrahmens definierte Ebene und kann als eine Art Anschlag bzw. Abstandhalter im Bereich der Detektionsöffnung dienen, so dass zum einen das Dichtmittel bei der Befestigung der Annäherungserfassungsvorrichtung an der Fahrzeugkarosserie nicht zu stark komprimiert wird und bei der Befestigung eine durch die Höhe der Erhebung definierter Abstand der aktiven kapazitiven Fläche zu dem Karosserieteil des Kraftfahrzeuges nicht unterschritten wird. Bei entsprechender Ausgestaltung des Sensorträgers können auch Abschnitte bzw. Teilbereiche des kapazitiven Annäherungssensors in diesen Bereichen angeordnet werden, so dass die aktive kapazitive Fläche des Sensors einen geringeren Abstand zu dem Karosserieteil hat.

Die Annäherungserfassungsvorrichtung wird über den Befestigungsabschnitt an einem Karosserieteil des Kraftfahrzeuges befestigt. Beispielsweise kann die Annäherungserfassungsvorrichtung über in dem Befestigungsabschnitt vorhandenen Öffnungen mit entsprechenden Befestigungsmitteln an der Karosserie des Kraftfahrzeuges verschraubt werden. Eine entsprechende Befestigung ist jedoch insofern nachteilig, als das ein Eingriff in das Karosseriebauteil stattfindet und zusätzliche Befestigungsmittel notwendig sind. Eine bevorzugte Ausführungsform der Annäherungserfassungsvorrichtung ist dadurch gekennzeichnet, dass auf der dem Karosserieteil des Kraftfahrzeuges zugewandten Fläche des Befestigungsabschnitts des Trägerrahmens zumindest abschnittsweise eine Klebebeschichtung angeordnet ist, mit welcher die Annäherungserfassungsvorrichtung an dem Karosserieteil des Kraftfahrzeuges befestigbar ist. Die Notwendigkeit zusätzlicher Befestigungsmittel, die in das Karosserieteil eingreifen, ist nicht mehr gegeben, die Annäherungserfassungsvorrichtung lässt sich rasch und ohne großen Aufwand über die Klebebeschichtung an dem Karosserieteil befestigen. In diesem Zusammenhang sind die Durchgangsöffnungen in dem Dichtmittel besonders vorteilhaft, da aufgrund des verminderten Expansionsdruckes des Dichtmittels die der Anhaftung entgegenwirkende Kraft vermindert ist, so dass die Kombination Verklebung/Anordnung von Durchgangsöffnungen in dem Dichtmittel positiv zusammenwirkt.

Das Dichtmittel kann vollständig aus einem speziellen Kunststoff gefertigt sein. Bei einer bevorzugten Ausführungsform der Annäherungserfassungsvorrichtung ist das Dichtmittel mehrschichtig aufgebaut, wobei die an dem Sensorträger anliegende und die zur Auflage an das Karosserieteil gelangenden Schichten weicher sind. Dies trägt weiter zur Verminderung des Expansionsdruckes des Dichtmittels bei, ohne dass dies zu Lasten der generellen Stabilität und Schutzwirkung des Dichtmittels geht.

Die erfindungsgemäße Annäherungserfassungsvorrichtung ist modular aus einfachen Bauteilen aufgebaut, so dass die Kosten gering gehalten werden können. Um zu vermeiden, dass für verschiedene Fahrzeugtypen verschiedene Trägerrahmen vorrätig gehalten werden müssen, die an die Formgebung des Karosserieteiles, an welchem die Annäherungserfassungsvorrichtung befestigt werden soll, angepasst sind, ist bei einer bevorzugten Ausführungsform der Annäherungserfassungsvorrichtung auf dem Befestigungsabschnitt eine die Detektionsöffnung freigebende Adapterschicht angeordnet, über welche die Annäherungserfassungsvorrichtung an dem Karosserieteil des Kraftfahrzeuges befestigbar ist. Die Befestigung kann wiederum durch eine auf der Adapterschicht angeordnete Klebebeschichtung oder andere, dem Fachmann bekannte Befestigungsmittel erfolgen. Die Verwendung der Adapterschicht hat den Vorteil, dass sämtliche verbleibenden Bauteile der Annäherungserfassungsvorrichtung unabhängig von der speziellen Formgebung des Karosserieteiles, an welchem die Annäherungserfassungsvorrichtung befestigt werden soll, sind. Bei verschieden geformten Karosserieteilen ist somit lediglich eine Anpassung der Adapterschicht notwendig; sämtliche andere Bauteile sind unabhängig von der Formgebung des Karosserieteiles.

Bei einem bevorzugten Ausführungsbeispiel der Annäherungserfassungsvorrichtung weist der Sensorträger einen Stützabschnitt und die Sensorelektronik einen Steckverbinder auf, wobei der Steckverbinder lösbar in dem Stützabschnitt befestigt ist. Über den Steckverbinder wird die Sensorelektronik in dem Sensorträger mit der Fahrzeugelektronik verbunden, wobei der Steckverbinder vorzugsweise als Schnellverschluss ausgebildet ist, so dass ein rascher Anschluss an die Fahrzeugelektronik möglich ist. Der Steckverbinder fasst sämtliche elektrischen Leitungen der Sensorelektronik zusammen, so dass bei Vorhandensein eines entsprechenden Steckverbinders auf Seiten des Kraftfahrzeuges eine schnelle, gegen Witterungseinflüsse geschützte und sichere Verbindung hergestellt werden kann.

Im Nachfolgenden wird die erfindungsgemäße Annäherungserfassungsvorrichtung anhand der Zeichnung detaillierter beschrieben, in welcher
Figuren 1A-1C verschiedene Ansichten einer ersten Ausführungsform der Annäherungserfassungsvorrichtung zeigen,
Figur 2 eine Seitenansicht der Ausführungsform gemäß den Figuren 1A-1C mit entfernten Dichtmittel zeigt,
Figur 3 eine Explosionsdarstellung der Ausführungsform gemäß der Figuren 1A-1C zeigt, und
Figur 4 eine detailliertere Explosionsdarstellung einer zweiten Ausführungsform zeigt.

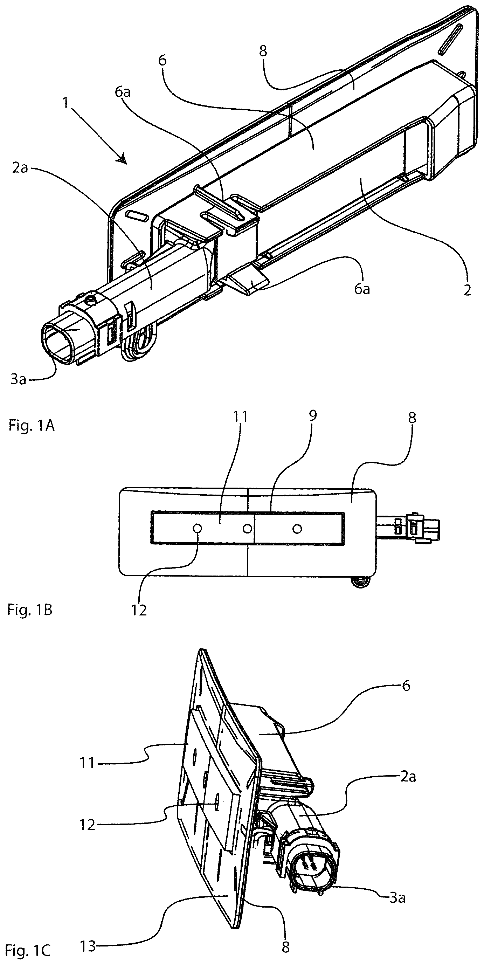

Die Figuren 1A-1C zeigen verschiedene Ansichten einer ersten Ausführungsform der erfindungsgemäßen Annäherungserfassungsvorrichtung 1.

Die Annäherungserfassungsvorrichtung umfasst einen einen ersten (in Figur 1A nicht erkennbaren) Aufnahmeraum aufweisenden Sensorträger 2 und einen Trägerrahmen 6, der einen Befestigungsabschnitt 8 (siehe Fig. 1B) und eine Detektionsöffnung 9 aufweist. Über den Befestigungsabschnitt 8 kann die Annäherungserfassungsvorrichtung 1 an einem Karosserieteil eines Kraftfahrzeuges befestigt werden. Dazu kann auf der dem Karosserieteil des Kraftfahrzeuges zugewandten Fläche des Befestigungsabschnittes 8 des Trägerrahmens 6 zumindest abschnittsweise eine Klebebeschichtung 13 angeordnet sein, über welche die Annäherungserfassungsvorrichtung 1 an dem Karosserieteil befestigbar ist. Alternativ kann die Annäherungserfassungsvorrichtung 1 über beispielsweise Schrauben mit dem Karosserieteil befestigt sein.

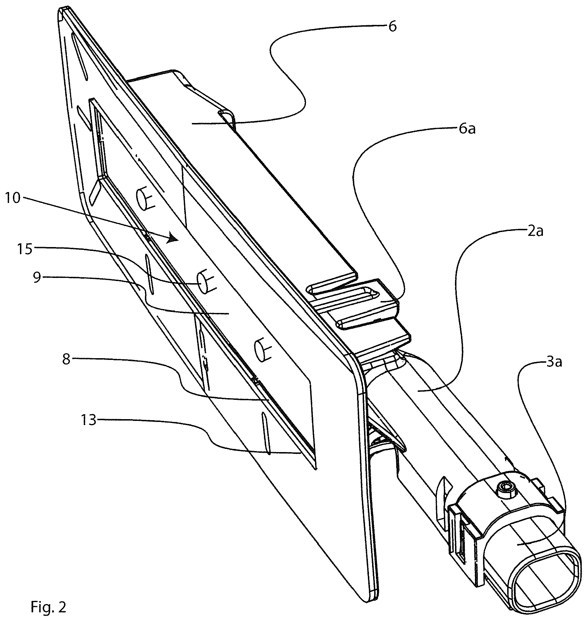

Der Trägerrahmen 6 umfasst einen zweiten Aufnahmeraum 10 (siehe dazu Figur 2), in welchem der Sensorträger 2 angeordnet ist. Bei der gezeigten Ausführungsform umfasst der Trägerrahmen zwei Haltemittel 6a sowie eine Aufnahmeöffnung 6b, über welche der Sensorträger 2 in bzw. an dem zweiten Aufnahmeraum des Trägerrahmens 6 festgelegt ist.

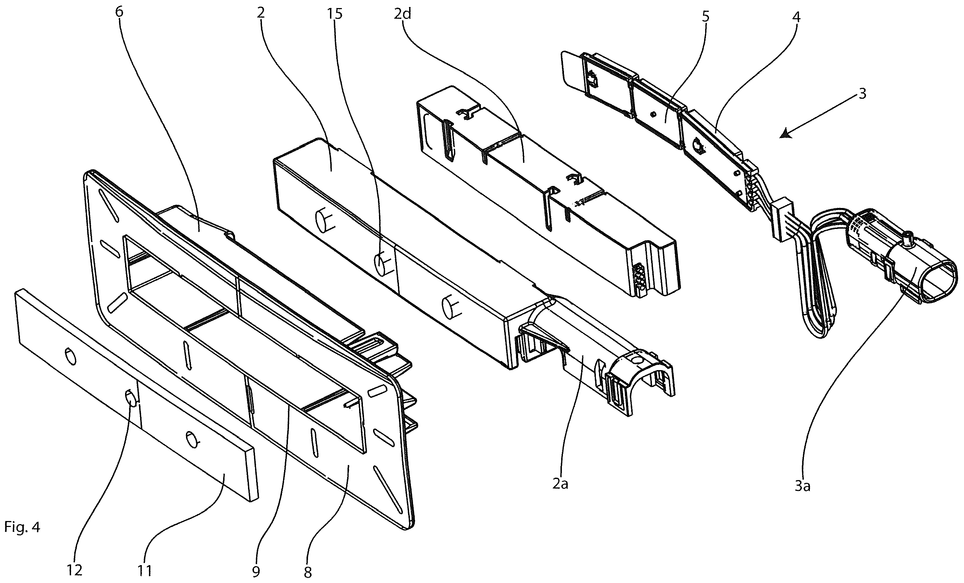

In dem Sensorträger wiederum ist eine (in den Figuren 1A-1C nicht erkennbare) Sensorelektronik 3 angeordnet, die zumindest einen mit einer Auswerteschaltung gekoppelten kapazitiven Annäherungssensor 4 mit einer aktiven kapazitiven Fläche 5 zur Erfassung von Annäherungen aufweist. Die Sensorelektronik 3 bzw. deren Anordnung in dem Sensorträger 2 ist mit der in Figur 4 gezeigten vergleichbar, wobei bei der in Figur 4 gezeigten zweiten Ausführungsform ein weiteres Bauelement verwendet wird, welches bei der ersten Ausführungsform nicht vorgesehen ist.

Die Sensorelektronik ist derart in dem Sensorträger 2 angeordnet, dass die aktive kapazitive Fläche 5 des kapazitiven Annäherungssensors 4 in Richtung auf die Detektionsöffnung 9 in dem Trägerrahmen 6 ausgerichtet ist, das heißt die Detektionsöffnung 9 die aktive kapazitive Fläche 5 des kapazitiven Annäherungssensors 4 freigibt, um eine Beeinflussung der Detektion zu vermeiden.

Der Sensorträger 2 wiederrum ist derart in dem Trägerrahmen 6 angeordnet, dass die der Detektionsöffnung 9 zugewandte Fläche des Sensorträgers nicht mit der durch den Befestigungsabschnitt 8 des Trägerrahmens 6 gebildeten Ebene abschließt, sondern vielmehr von dieser Ebene nach innen verlagert ist, so dass die Detektionsöffnung 9 und der Sensorträger 2 den zweiten Aufnahmeraum 10 bilden, in welchem ein Dichtmittel 11 angeordnet ist.

Der zweite Aufnahmeraum 10 ist insbesondere bei der in Figur 2 dargestellten seitlichen Ansicht der in den Figuren 1A-1C gezeigten Ausführungsform zu erkennen. Bei Figur 2 ist die Klebebeschichtung 13 auf dem Befestigungsabschnitt 8 des Trägerrahmens 6 besonders deutlich zu erkennen.

Das Dichtmittel 11 umfasst drei Durchgangsöffnungen 12. Diese Durchgangsöffnungen 12 vermindern den Expansionsdruck des Dichtmittels, welcher sich durch die Komprimierung des Dichtmittels bei der Befestigung des Annäherungserfassungssensors 1 an dem Karosserieteil bildet; wie insbesondere in Figur 1C zu sehen ist, ragt das Dichtmittel in der nicht-befestigten Form der Annäherungserfassungsvorrichtung 1 bei der ersten Ausführungsform über die von dem Befestigungsabschnitt 8 des Trägerrahmens 6 gebildeten Ebene hinaus, so dass bei Befestigung an dem Karosserieteil eine Komprimierung des Dichtmittels stattfindet.

Auf der der Detektionsöffnung 9 zugewandten Oberfläche des Sensorträgers 2 sind bei der ersten Ausführungsform drei Erhebungen 15 vorgesehen, die zu den Durchgangsöffnungen 12 in dem Dichtmittel 11 komplementär sind. Die Erhebungen fixieren das Dichtmittel in dem zweiten Aufnahmeraum (das Dichtmittel muss nicht, wie bei der ersten Ausführungsform angedeutet, den gesamten zweiten Aufnahmeraum 10 ausfüllen) und gewährleisten ferner, dass keine zu starke Komprimierung des Dichtmittels 11 bei der Anbringung der Annäherungserfassungsvorrichtung stattfindet.

Der Sensorträger 2 umfasst einen Stützabschnitt 2a, in welchem ein Steckverbinder 3a als Teil der Sensorelektronik 3 gehalten ist. Über diesen Steckverbinder 3a wird die Sensorelektronik 3 der Annäherungserfassungsvorrichtung mit der Fahrzeugelektronik verbunden. Die Sensorelektronik 3 kann die mit dem kapazitiven Annäherungssensor 4 gekoppelte Auswerteschaltung enthalten, diese kann jedoch auch Teil der Fahrzeugelektronik sein. Mit Hilfe des Steckverbinders 3a lässt sich die Sensorelektronik schnell und sicher mit der vorgenannten Fahrzeugelektronik verbinden.

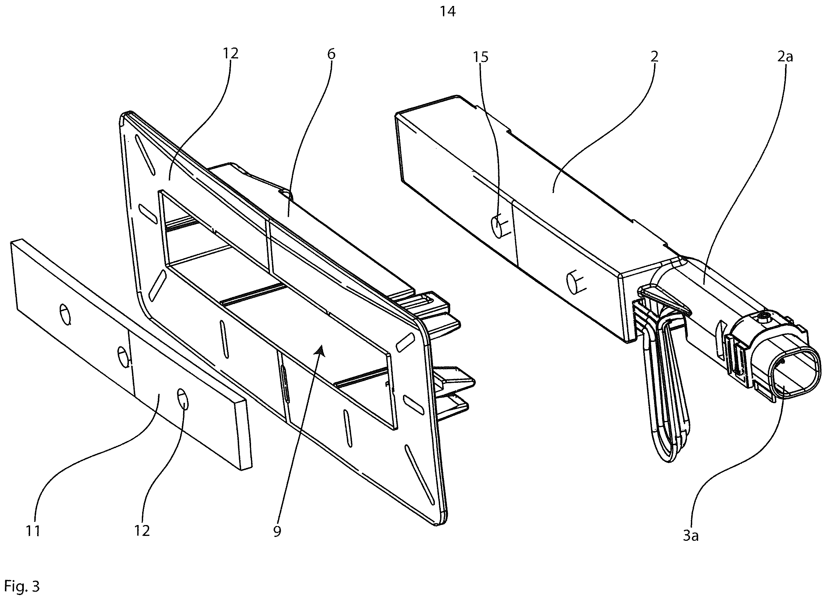

Die Figur 3 zeigt eine Explosionsdarstellung der in den Figuren 1A-1C gezeigten Ausführungsform der erfindungsgemäßen Annäherungserfassungsvorrichtung, wobei insbesondere das Dichtmittel 11 mit den Durchgangsöffnungen 12, der Trägerrahmen 6 mit Befestigungsabschnitt 8 und Detektionsöffnung 9 sowie der Sensorträger 2 mit Stützabschnitt 2a zu erkennen sind. Bei der Darstellung gemäß Figur 3 ist insbesondere der modulare Aufbau der erfindungsgemäßen Annäherungserfassungsvorrichtung zu erkennen.

Figur 4 zeigt eine detaillierte Explosionsdarstellung einer zweiten Ausführungsform der erfindungsgemäßen Annäherungserfassungsvorrichtung. Bei dieser Darstellung sind Details der Sensorelektronik zu erkennen; eine entsprechend aufgebaute (nicht unbedingt identische) Sensorelektronik 3 ist auch Teil der ersten Ausführungsform, wobei die Sensorelektronik zur Vermeidung übermäßiger Details bei den Figuren 1A - 1C, sowie 2 und 3 nicht dargestellt ist.

Die Sensorelektronik 3 umfasst einen kapazitiven Annäherungssensor 4, der in dem vorliegenden Fall drei Elektroden umfasst, die eine aktive kapazitive Fläche 5 bilden. Die Anzahl der Elektroden und deren genaue räumliche Anordnung in dem Sensorträger ist abhängig von dem jeweiligen Anwendungsfall und nicht auf die dargestellt spezielle Anordnung beschränkt.

Bei der in dieser Figur gezeigten Ausführungsform umfasst der Sensorträger ein Stützelement 2d, in welchem die Sensorelektronik 3 fixiert ist, so dass eine Bewegung der Sensorelektronik in dem Sensorträger verhindert ist. Das Stützelement 2d ist speziell auf die Form der Sensorelektronik 3 abgestimmt. Sobald die Sensorelektronik 3 in dem Stützelement 2d befestigt ist, wird dieses einfach in den Sensorträger 2 eingeschoben, welcher dann wiederum in bzw. an dem Trägerrahmen 6 festgelegt wird. Der Sensorträger 2 und der Trägerrahmen 6 sind bei der gezeigten Ausführungsform unabhängig von der Gestaltung der Sensorelektronik 3, da diese über das Stützelement in dem Sensorträger festgelegt wird.

Die Sensorelektronik 3 variiert je nach Anwendungsgebiet und Ausgestaltung des Karosserieteils, an welchem die Annäherungserfassungsvorrichtung zu befestigen ist. Je nach Ausgestaltung der Sensorelektronik 3, und insbesondere des kapazitiven Annäherungssensors 4 der Sensorelektronik 3, ist das Dichtmittel 11 gestaltet. Bei den gezeigten Ausführungsformen ist das Dichtmittel derart auf dem Sensorträger 2 angeordnet, dass die komplette Detektionsöffnung 9 ausgefüllt war. Bei anderen Ausführungsformen, bei denen ein kleinerer kapazitiver Annäherungssensor 4 verwendet wird, kann es ausreichend sein, dass das Dichtmittel lediglich den Abschnitt der Detektionsöffnung 9 ausfüllt, in welchem tatsächlich die aktive kapazitive Fläche 5 an der Wandung des Sensorträgers 2 anliegt.

## Patentansprüche

1. Annäherungserfassungsvorrichtung (1) für Kraftfahrzeuge, mit
einem einen ersten Aufnahmeraum aufweisenden Sensorträger (2),
einer in dem ersten Aufnahmeraum des Sensorträgers (2) angeordneten Sensorelektronik (3), die zumindest einen mit einer Auswerteschaltung gekoppelten kapazitiven Annäherungssensor (4) mit einer aktiven kapazitiven Fläche (5) zur Erfassung von Annäherungen aufweist, und
einem Trägerrahmen (6), der einen Befestigungsabschnitt (8), mit welchem die Annäherungserfassungsvorrichtung (1) an einem Karosserieteil des Kraftfahrzeuges befestigbar ist, und eine Detektionsöffnung (9) umfasst,
wobei der Sensorträger (2) derart an dem Trägerrahmen (6) befestigt ist, dass die aktive kapazitive Fläche des kapazitiven Annäherungssensors (4) zur Detektionsöffnung ausgerichtet und von dieser freigegeben ist, und
dass in dem Bereich der Detektionsöffnung (9) ein von der Detektionsöffnung (9) und dem Sensorträger definierter zweiter Aufnahmeraum (10) gebildet ist,
und mit einem Dichtmittel (11), welches in dem zweiten Aufnahmeraum (10) auf dem Sensorträger zumindest im Bereich der aktiven kapazitiven Fläche (5) des kapazitiven Annäherungssensors (5) angeordnet ist,
**dadurch gekennzeichnet, dass** das Dichtmittel (11) zumindest eine Durchgangsöffnung (12) zur Verringerung des Expansionsdruckes des Dichtmittels aufweist.

2. Annäherungserfassungsvorrichtung (1) nach Anspruch 1, wobei der Sensorträger (2) in dem von dem zweiten Aufnahmeraum (10) freigegebenen Bereich zumindest eine zu einer Durchgangsöffnung (12) komplementäre Erhebung (15) aufweist.

3. Annäherungserfassungsvorrichtung (1) nach einem der Ansprüche 1 oder 2, wobei auf der dem Karosserieteil des Kraftfahrzeuges zugewandten Fläche des Befestigungsabschnitts (8) des Trägerrahmens (6) zumindest abschnittsweise eine Klebebeschichtung (13) angeordnet ist, mit welcher die Annäherungserfassungsvorrichtung (1) an dem Karosserieteil des Kraftfahrzeuges befestigbar ist.

4. Annäherungserfassungsvorrichtung (1) nach einem der Ansprüche 1 - 3, wobei das Dichtmittel (11) mehrschichtig aufgebaut ist, wobei die an dem Sensorträger anliegende und die zur Anlage an das Karosserieteil gelangenden Schichten weicher sind.

5. Annäherungserfassungsvorrichtung (1) nach einem der Ansprüche 1 - 4, wobei auf dem Befestigungsabschnitt eine die Detektionsöffnung freigebende Adapterschicht angeordnet ist, mit welcher die Annäherungserfassungsvorrichtung (1) an dem Karosserieteil des Kraftfahrzeuges befestigbar ist.

6. Annäherungserfassungsvorrichtung (1) nach einem der Ansprüche 1 - 5, wobei der Trägerrahmen mehrere Haltemittel (6a, 6b) umfasst, mit welchen der Sensorträger (2) in bzw. an dem Trägerrahmen fixiert ist.

7. Annäherungserfassungsvorrichtung (1) nach einem der Ansprüche 1 - 5, wobei der Sensorträger (2) einen Stützabschnitt (2a) und die Sensorelektronik (3) einen Steckverbinder (3a) aufweist, wobei der Steckverbinder (3a) lösbar in dem Stützabschnitt (2a) befestigt ist.

## Claims

1. Approach detection device (1) for motor vehicles, with a sensor carrier (2) having a first receiving space, a sensor electronic system (3) which is arranged in the first receiving space of the sensor carrier (2) and has at least one capacitive approach sensor (4) which is coupled to an evaluation circuit and has an active capacitive surface (5) for detecting approaches, and a carrier frame (6) comprising a fastening section (8), with which the approach detection device (1) can be fastened to a body part of the motor vehicle, and a detection opening (9), wherein the sensor carrier (2) is fastened to the carrier frame (6) in such manner that the active capacitive surface of the capacitive approach sensor (4) is aligned with the detection aperture and exposed thereby, and that a second receiving space (10) defined by the detection opening (9) and the sensor carrier is formed in the area of the detection opening (9), and with a sealing means (11) which is arranged at least in the region of the active capacitive surface (5) of the capacitive approach sensor (4) in the second receiving space (10) on the sensor carrier, **characterised in that** the sealing means (11) has at least one through opening (12) for reducing the expansion pressure of the sealing means.

2. Approach detection device (1) according to claim 1, wherein the sensor carrier (2) has at least one raised portion (15) complementary to through opening (12) in the area exposed by the second receiving space (10).

3. Approach detection device (1) according to either of claims 1 or 2, wherein an adhesive coating (13) is arranged on a least portions of the surface of the fastening section (8) of the carrier frame (6) facing the body part of the motor vehicle, with which adhesive coating the approach detection device (1) can be fastened to the body part of the motor vehicle.

4. Approach detection device (1) according to any one of claims 1 to 3, wherein the sealing means (11) has a multilayer structure, wherein the layers adjacent to the sensor carrier and the layers that come to bear on the body part are softer.

5. Approach detection device (1) according to any one of claims 1 to 4, wherein an adapter layer that exposes the detection opening and with which the approach detection device (1) can be fastened to the body part of the motor vehicle, is arranged on the fastening section.

6. Approach detection device (1) according to any one of claims 1 to 5, wherein the carrier frame comprises a plurality of retaining means (6a, 6b) with which the sensor carrier (2) is fixed in or on the carrier frame.

7. Approach detection device (1) according to any one of claims 1 to 5, wherein the sensor carrier (2) has a support section (2a) and the sensor electronic system (3) has a plug connector (3a), wherein the plug connector (3a) fastened detachably in the support section (2a).

## Revendications

1. Dispositif de détection de sécurité (1) pour véhicules automobiles, comportant
un support de détecteur (2) présentant un premier espace de réception,
un système électronique de détecteur (3) disposé dans le premier espace de réception du support de détecteur (2) et qui présente au moins un détecteur de proximité (4) couplé à un circuit d'exploitation doté d'une surface capacitive active (5) pour détecter des proximités, et
un cadre support (6) qui comprend une section de fixation (8) grâce à laquelle le dispositif de détection de proximité (1) peut être fixé à une pièce de carrosserie du véhicule automobile, et une ouverture de détection (9),
dans lequel le support de détecteur (2) est fixé au cadre support (6) de manière à ce que la surface capacitive active du détecteur de proximité capacitif (4) soit orientée vers l'ouverture de détection et libérée par celle-ci et,
que, au niveau de l'ouverture de détection (9), un second espace récepteur (10) défini par l'ouverture de détection (9) et le support de détecteur est constitué,
et comportant un moyen d'étanchéité (11) qui est disposé dans le second espace récepteur (10) sur le support de détecteur du moins au niveau de la surface capacitive active (5) du détecteur de proximité capacitif (4),
**caractérisé en ce que** le moyen d'étanchéité (11) présente au moins une ouverture de passage (12) pour réduire la pression d'extension du moyen d'étanchéité.

2. Dispositif de détection de proximité (1) selon la revendication 1, dans lequel le support de détecteur (2) présente, dans la zone libérée par le second espace récepteur (10), au moins une protubérance (15) complémentaire à une ouverture de passage (12).

3. Dispositif de détection de proximité (1) selon une des revendications 1 ou 2, dans lequel, sur la surface tournée vers la pièce de carrosserie du véhicule automobile de la section de fixation (8) du cadre support (6), est disposée au moins par sections un revêtement collant (13) au moyen duquel le dispositif de détection de proximité (1) peut être fixé sur la pièce de carrosserie du véhicule automobile.

4. Dispositif de détection de proximité (1) selon une des revendications 1 à 3, dans lequel le moyen d'étanchéité (11) a une structure multicouche, les couches reposant sur le support de détecteur et venues en contact avec la pièce de carrosserie étant plus molles.

5. Dispositif de détection de proximité (1) selon une des revendications 1 à 4, dans lequel, sur la section de fixation, est fixée une couche d'adaptation libérant l'ouverture de détection (1) et sur laquelle la pièce de carrosserie du véhicule automobile peut être fixée.

6. Dispositif de détection de proximité (1) selon une des revendications 1 à 5, dans lequel le cadre support comprend plusieurs moyens de retenue (6a, 6b) grâce auxquels le support de détecteur (2) est fixé sur le ou au cadre support.

7. Dispositif de détection de proximité (1) selon une des revendications 1 à 5, dans lequel le support de détecteur (2) présente une section d'appui (2a) et le système électronique de détection (3) un connecteur enfichable (3a), le connecteur enfichable (3a) étant fixé de manière amovible dans la section d'appui (2a).
